# EUROPÄISCHE PATENTANMELDUNG

(11) **EP 4 737 931 A1**
(43) Veröffentlichungstag der Anmeldung: **06.05.2026**
(21) Anmeldenummer: 25209896.7
(22) Anmeldetag: 20.10.2025
(51) Int. Cl.: G01R 31/58, H01B 13/012, B25J 9/16, G01N 21/88, G05B 19/418, G06T 7/00, G01M 5/00

(54) **VERFAHREN ZUR WARTUNG EINES PRÜFTISCHES MITTELS EINER WARTUNGSEINHEIT UND WARTUNGSEINHEIT**

(30) Priorität: 31.10.2024 DE 102024210527
(71) Anmelder: Leoni Wiring Systems Tunisia Sarl, 4013 M'saken-Sousse (TN)
(72) Erfinder: LETAIEF, Kilani, 4021 Kalaa Sghira (TN)
(74) Vertreter: FDST Patentanwälte

(57) **Zusammenfassung**

Es wird ein Verfahren zur Wartung eines Prüftisches (2) mittels einer Wartungseinheit (4) angegeben, wobei der Prüftisch (2) eine Oberfläche (6) aufweist, mit wenigstens einem Prüfmodul (8) zum Anschließen und Prüfen eines Kabelsatzes, wobei die Wartungseinheit (4) eine Sensoreinheit (10) aufweist, welche über der Oberfläche (6) positioniert ist, wobei die Wartungseinheit (4) mit der Sensoreinheit (10) das Prüfmodul (8) erkennt und einen Ist-Zustand des Prüfmoduls (8) bestimmt, wobei die Wartungseinheit (10) eine ID des Prüfmoduls (8) ermittelt, wobei die Wartungseinheit (4) anhand der ID aus einer Datenbank (14) einen Soll-Zustand für das Prüfmodul (8) abruft, wobei die Wartungseinheit (4) den Ist-Zustand mit dem Soll-Zustand vergleicht und abhängig davon eine Wartungsaktion für das Prüfmodul (8) automatisch ausführt. Weiter wird eine entsprechende Wartungseinheit (4) angegeben.

## Beschreibung

Die Erfindung betrifft ein Verfahren zur Wartung eines Prüftisches mittels einer Wartungseinheit sowie eine solche Wartungseinheit. Der Prüftisch dient insbesondere zur Prüfung von Kabelsätzen, die Wartung erfolgt insbesondere am Prüftisch ohne daran angeschlossenen Kabelsatz.

Ein Kabelsatz ist zusammengesetzt aus mehreren Kabeln und/oder Leitungen und weist gegebenenfalls zusätzlich noch Medienschläuche und dergleichen auf. Gegebenenfalls sind zusätzlich noch ein oder mehrere Funktionsmodule vorhanden, um anwendungsabhängige Funktionen zu implementieren. Ein Kabelsatz weist zudem regelmäßig entsprechende Steckverbinder am Ende oder entlang der Kabel und Leitungen auf, um den Kabelsatz in ein Gesamtsystem, z.B. ein Fahrzeug, zu integrieren. Ein Kabelsatz wird beispielsweise in einem Bordnetz eines Fahrzeugs verwendet.

Während oder nach der Herstellung eines einzelnen Kabelsatzes ist es zweckmäßig, diesen zu prüfen, um dessen ordnungsgemäße Funktionalität sicherzustellen und gegebenenfalls vorhandene Defekte zu beheben, bevor der Kabelsatz dann in ein Gesamtsystem integriert wird. Zur Prüfung wird ein sogenannter Prüftisch (auch: Testtisch) verwendet, in welchen mehrere Prüfmodule integriert sind. Der Kabelsatz wird an die diversen Prüfmodule angeschlossen und mittels dieser dann geprüft. Beispielsweise werden mittels der Prüfmodule elektrische oder hydraulische Eigenschaften wie Strom, Spannung, Widerstand, Druck, Dichtigkeit etc. entlang einzelner oder mehrerer Kabel, Leitungen und Schläuche des Kabelsatzes gemessen.

Die Prüfung eines Kabelsatzes erfordert eine einwandfreie Funktionalität des Prüftisches, welcher daher regelmäßig gewartet werden sollte, z.B. nach einer festgelegten Anzahl an geprüften Kabelsätzen, nach einer bestimmten Anzahl an Betriebsstunden oder nachdem Prüfmodule ausgetauscht/ergänzt/entfernt wurden, um einen anderen Kabelsatz zu prüfen. Im Rahmen der Wartung werden die Prüfmodule beispielsweise gereinigt und/oder auf ordnungsgemäße Funktionalität überprüft. Die Wartung wird typischerweise manuell von einem Techniker durchgeführt und ist dadurch entsprechend zeitaufwendig und fehleranfällig.

Es wird verwiesen auf DE 10 2022 204 788 A1.

Vor diesem Hintergrund ist es eine Aufgabe der Erfindung, die Wartung eines Prüftisches zu verbessern. Insbesondere soll die Wartung möglichst schnell und möglichst fehlerfrei sein. Hierzu sollen ein entsprechendes Verfahren sowie eine dabei verwendete Wartungseinheit angegeben werden.

Die Aufgabe wird erfindungsgemäß gelöst durch ein Verfahren zur Wartung eines Prüftisches mittels einer Wartungseinheit, wobei der Prüftisch eine Oberfläche aufweist, mit wenigstens einem Prüfmodul zum Anschließen und Prüfen eines Kabelsatzes, wobei die Wartungseinheit eine Sensoreinheit aufweist, welche über der Oberfläche positioniert ist, wobei die Wartungseinheit mit der Sensoreinheit das Prüfmodul erkennt und einen Ist-Zustand des Prüfmoduls bestimmt, wobei die Wartungseinheit eine ID des Prüfmoduls ermittelt, wobei die Wartungseinheit anhand der ID aus einer Datenbank einen Soll-Zustand für das Prüfmodul abruft, wobei die Wartungseinheit den Ist-Zustand mit dem Soll-Zustand vergleicht und abhängig davon eine Wartungsaktion für das Prüfmodul automatisch ausführt. Beispielsweise wird durch Kenntnis des genauen Prüfmoduls und dessen Zustand ein Hinweis auf ein benötigtes Ersatzteil ausgegeben oder gegebenenfalls sogar direkt eine entsprechende interne oder externe Bestellung eines solchen Ersatzteils veranlasst.

Die Aufgabe wird erfindungsgemäß auch gelöst durch eine Wartungseinheit für ein solches Verfahren.

Vorteilhafte Ausführungen, Weiterbildungen und Varianten sind Gegenstand der Unteransprüche. Die Ausführungen im Zusammenhang mit dem Verfahren gelten sinngemäß auch für die Wartungseinheit und umgekehrt. Sofern nachfolgend Schritte des Verfahrens beschrieben sind, ergeben sich zweckmäßige Ausgestaltungen für die Wartungseinheit dadurch, dass diese ausgebildet ist, einen oder mehrere dieser Schritte auszuführen. Hierfür weist die Wartungseinheit insbesondere eine entsprechend ausgebildete Steuereinheit auf.

Das erfindungsgemäße Verfahren dient zur Wartung eines Prüftisches (auch als Testtisch bezeichnet). Die Wartung erfolgt mittels einer Wartungseinheit, welche separat zu dem Prüftisch ausgebildet ist oder in diesen integriert ist. Die Wartungseinheit ist insbesondere ein Roboter. Der Prüftisch weist allgemein eine Oberfläche (auch: Oberseite) auf, mit wenigstens einem Prüfmodul, zum Anschließen und Prüfen eines Kabelsatzes. Entsprechend stellt jedes Prüfmodul eine Schnittstelle des Prüftisches zum Kabelsatz dar. Typischerweise weist der Prüftisch mehrere Prüfmodule auf, z.B. mehrere hundert Stück, wovon nachfolgend auch ohne Beschränkung der Allgemeinheit ausgegangen wird. Ein jeweiliges Prüfmodul weist insbesondere einen z.B. elektrischen, mechanischen, hydraulischen und/oder optischen Anschluss für den Kabelsatz auf und einen Sensor, um eine Präsenz, Funktionalität oder dergleichen des Kabelsatzes zu prüfen. Der Prüftisch ist insbesondere modular, d.h. an verschiedenen Stellen der Oberfläche können verschiedene Prüfmodule je nach konkreter Ausgestaltung des zu prüfenden Kabelsatzes montiert werden. Auf die Details des Prüfmoduls hinsichtlich der Prüfung des Kabelsatzes kommt es vorliegend aber nicht an. Auch auf die Details des Kabelsatzes kommt es vorliegend nicht an, für diesen gelten aber insbesondere die einleitenden Ausführungen oben. Der Kabelsatz selbst ist somit nicht Gegenstand der hier beschriebenen Wartung, diese betrifft ausschließlich den Prüftisch an sich und speziell dessen Prüfmodule. Die Prüfung und/oder Montage des Kabelsatzes unter Verwendung des Prüftisches erfolgt üblicherweise durch einen Techniker und ist nicht Gegenstand des erfindungsgemäßen Verfahrens.

Das Verfahren ist grundsätzlich für verschiedenste Prüftische geeignet, jedoch besonders vorteilhaft bei sehr großen Prüftischen, bei welchen nicht die gesamte Oberfläche auf einfache Weise für einen Techniker zugänglich ist. Unter einem "sehr großen" Prüftisch wird insbesondere ein Prüftisch verstanden, welcher mehrere Meter, z.B. wenigstens 5 m, lang und breit ist oder zumindest in einer Richtung sehr groß ist, z.B. mehr als 20 m lang oder breit. Beispielsweise sind Längen von mehr 80 m möglich, ein solcher Prüftisch weist oft mehrere hundert Prüfmodule auf. Auch unterschiedliche Formen von Prüftischen sind möglich, insbesondere die typischerweise verwendeten U-, I-, H-, und L-Formen. Bei der Prüfung mehrere Prüftische ist es vorteilhaft, wenn die Wartungseinheit separat ausgebildet ist und dann nacheinander von Prüftisch zu Prüftisch versetzt wird, insbesondere vollautomatisch oder manuell.

Die Wartungseinheit weist eine Sensoreinheit auf, welche über der Oberfläche positioniert ist und optional als Teil des Verfahrens über der Oberfläche positioniert wird. Mit der Sensoreinheit erkennt die Wartungseinheit das Prüfmodul und bestimmt einen Ist-Zustand des Prüfmoduls. Mit anderen Worten: mit der Sensoreinheit erfolgt sowohl eine Erkennung der Präsenz des Prüfmoduls sowie eine Erkennung von dessen aktuellen Zustand (Ist-Zustand).

Die Wartungseinheit ermittelt weiter eine ID des Prüfmoduls, dies erfolgt insbesondere ebenfalls mit der Sensoreinheit, welche hierzu entsprechend ausgebildet ist. Durch die Bestimmung der ID wird das Prüfmodul identifiziert, d.h. zusätzlich zur bloßen Erkennung der Präsenz erfolgt auch eine Erkennung, was für ein Prüfmodul konkret vorhanden ist. Die ID ist eine Kennzeichnung des Prüfmoduls und beschreibt z.B. einen Typ, eine Art des Prüfmoduls, ein Installationsdatum, ein Verifikationsdatum (verification date) oder individualisiert dies als ein ganz bestimmtes Prüfmodul aus einer Menge mehrerer Prüfmodule. Die ID kann grundsätzlich auf verschiedene Weise von der Wartungseinheit ermittelt werden, z.B. per Bilderkennung, insbesondere zwecks Bestimmung wenigstens eines Charakteristikums (Merkmals) des Prüfmoduls, oder durch Auslesen eines Transponders des Prüfmoduls. Entsprechend geeignete Varianten sind weiter unten noch näher beschrieben.

Wichtiger als die Art der Ermittlung der ID ist zunächst, dass überhaupt eine ID ermittelt wird, d.h. dass das Prüfmodul überhaupt identifiziert wird. Denn anhand der ID ruft die Wartungseinheit nun aus einer Datenbank einen Soll-Zustand für das Prüfmodul ab. Die ID kann auf verschiedene Weise ausgestaltet sein. Beispielsweise ist die ID eine einfache Zeichenfolge im Sinne eines Namens oder einer Seriennummer, entweder individuell für nur ein einziges Prüfmodul oder verallgemeinernd für eine Gruppe gleichartiger Prüfmodule. Alternativ ist die ID einfach ein Bild des Prüfmoduls und/oder zusammengesetzt aus mehreren Charakteristika (Merkmalen) des Prüfmoduls, z.B. Form, Kontur, Farbe, Anzahl an Testpins usw., welche gegebenenfalls dem Bild entnommen werden. Abhängig von der konkreten Ausgestaltung der ID ergibt sich dann auch eine entsprechende Ausgestaltung der Wartungseinheit zur Ermittlung der ID. Die Datenbank ist entweder separat zur Wartungseinheit ausgebildet oder in diese integriert. In der Datenbank ist insbesondere für jedes Prüfmodul, welches potenziell in den Prüftisch integriert ist, ein Soll-Zustand hinterlegt. Der Soll-Zustand gibt insbesondere an, welchen Zustand das Prüfmodul aufweisen muss, um für die ordnungsgemäße Prüfung des Kabelsatzes geeignet zu sein. Dies hängt unter Umständen auch von der konkreten Ausgestaltung des Kabelsatzes ab. Mit dem "Zustand" (Ist-Zustand oder Soll-Zustand) des Prüfmoduls ist allgemein dessen Art, Typ, Funktion, Konfiguration, Position auf der Oberfläche, Funktionsfähigkeit, Betriebsbereitschaft, Verschmutzungsgrad, Beschädigungsgrad oder eine Kombination davon gemeint.

Die Wartungseinheit vergleicht dann den Ist-Zustand mit dem Soll-Zustand und führt abhängig davon eine Wartungsaktion für das Prüfmodul automatisch aus. Mit anderen Worten: es erfolgt ein Vergleich von Ist-Zustand und Soll-Zustand, anhand dessen ein möglicher Unterschied zwischen Ist-Zustand und Soll-Zustand festgestellt wird. Anhand des Unterschieds bewertet die Wartungseinheit dann insbesondere selbsttätig und automatisch, ob eine - und, wenn ja, welche - Wartungsaktion auszuführen ist. Die konkrete Ausgestaltung der Wartungsaktion ist zunächst von untergeordneter Bedeutung, wichtig ist vorerst nur, dass die Wartungsaktion geeignet ist, ausgehend von dem Ist-Zustand den Soll-Zustand herzustellen, um das Prüfmodul nachfolgend für die ordnungsgemäß Prüfung eines Kabelsatzes verwenden zu können.

Ein Kerngedanke der Erfindung ist insbesondere die Verwendung einer Wartungseinheit zur möglichst weitgehenden Automatisierung einer Wartung des Prüftisches und somit der weitestgehende Verzicht auf eine manuelle Prüfung durch einen Techniker. Die Wartung ist insbesondere definiert durch eine Anzahl an Wartungsaufgaben, welche im Rahmen der Wartung abzuarbeiten sind. Grundsätzlich ist es möglich die Wartung manuell durchzuführen, dies ist jedoch zeitaufwendig und aufgrund des menschlichen Faktors auch fehlerbehaftet. Da eine Wartung zudem wiederkehrend nötig ist, ist diese insgesamt sehr personalintensiv. Eine nicht korrekte Wartung kann jederzeit zu einem längeren Stillstand der eigentlichen Produktion (Montage und/oder Prüfung von Kabelsätzen) und damit zu hohen Kosten führen. Vorliegend wird daher der Prozess der Wartung so weit wie möglich automatisiert, vorzugsweise werden einem Techniker nur noch etwaige automatisiert gefundene Fehler etc. angezeigt, sodass sich der manuelle Anteil der Wartung auf ein Minimum reduziert. Dies führt insbesondere zu einer grundsätzlich vorteilhaften Prozessautomatisierung sowie zu einer Zeitersparnis und Effizienzsteigerung im Vergleich zu einer manuellen Wartung. Beispielsweise benötigt die manuelle Wartung eines einzelnen Prüfmoduls 30 min, die vorliegend vorgestellte automatische Wartung hingegen nur wenige Sekunden. Darüber hinaus ist die automatische Wartung durch die Wartungseinheit regelmäßig gründlicher, sodass z.B. Kurzschlüsse oder verschmutzte Steckverbinder am Prüftisch oder andere Fehler besser vermieden werden. Die Wartung ist zudem vorteilhaft unabhängig von der Arbeitszeit eines Technikers möglich, z.B. in Pausenzeiten. Auch werden Unterbrechungen in der Prüfung von Kabelsätzen vorteilhaft reduziert.

Eine manuelle Prüfung erfolgt beispielsweise, indem ein Techniker die folgenden Schritte ausführt:
1. Überprüfung, dass eine vorgegebene Anzahl an Testpins des Prüfmoduls vorhanden sind (Präsenzprüfung);
2. Überprüfung, ob die Testpins korrekt funktionieren (Funktionsprüfung);
3. manuelles Entriegeln des Prüfmoduls vom Prüftisch, insbesondere für den nachfolgenden Schritt;
4. Beschreiben der Charakteristika (Name, Index, Einbaudatum, Verifikationsdatum usw.) des Prüfmoduls, wobei diese Charakteristika auf einem Label am Prüfmodul angegeben sind;
5. Überprüfung eines Testdrucks des Prüfmoduls (sofern vorhanden);
6. Überprüfung der Position (Einbauposition) des Prüfmoduls auf der Oberfläche;
7. Dokumentation der Ergebnisse der vorstehenden Überprüfungen, z.B. in einer elektronischen Datenbank (auch: Registrierung des Prüfmoduls);
8. Reinigung des Prüfmoduls.

Das jeweilige Überprüfen enthält die Feststellung des Ist-Zustands durch den Techniker, typischerweise visuell, sowie dessen Vergleich mit einem vorgegebenen Soll-Zustand. Einer oder mehrere der vorgenannten Schritte werden nun automatisch durch die Wartungseinheit ausgeführt. Ein wichtiger Aspekt ist dabei die automatische Identifikation des Prüfmoduls, welche dann eine vollautomatische Wartung ermöglicht, da anhand der ID auf einfache Weise der Soll-Zustand für die Überprüfung (Vergleich von Ist-Zustand und Soll-Zustand) automatisch abgefragt werden kann. Auch die Dokumentation erfolgt vorzugsweise automatisch durch die Wartungseinheit, sodass die Dokumentation dann vorteilhaft frei von Medienbrüchen und weniger fehleranfällig ist. Bei dem hier vorgestellten Verfahren werden demnach so viele Schritte wie möglich durch ein intelligentes, automatisches System, nämlich die Wartungseinheit, durchgeführt. Je nachdem, wie die ID des Prüfmoduls konkret ermittelt wird, entfällt vorteilhaft auch das Erfordernis, dieses Prüfmodul zu entriegeln und aus der Oberfläche zu entnehmen.

Besonders bevorzugt ist eine Ausgestaltung, bei welcher die Wartungseinheit ein paralleler Seilroboter ist, bei welchem die Sensoreinheit an mehreren Seilen über der Oberfläche aufgehängt ist. Ein paralleler Seilroboter zeichnet sich insbesondere dadurch aus, dass dieser ein Gestell aufweist, über welches mehrere Seile geführt sind, an welchen eine Einheit beweglich gehalten ist. Durch eine geeignete Steuerung von Antrieben (z.B. Motoren) zum Einholen und Ausgeben der Seile wird die Einheit dann innerhalb des Gestells an verschiedene Positionen bewegt.

Das Gestell weist insbesondere mehrere, typischerweise vier vertikale Säulen (z.B. Ecksäulen) auf, welche das Innere des Gestells und damit einen Bewegungsraum definieren, welcher für die Einheit zugänglich ist. Das Gestell ist geeigneterweise verstellbar, vorzugsweise indem eine oder mehrere der Säulen in horizontaler Richtung (d.h. parallel zur Oberfläche) und/oder relativ zueinander verfahrbar sind oder indem eine oder mehrere der Säulen drehbar sind. Beispielsweise sind die Säulen jeweils auf einem Fahrgestell angebracht, um paarweise oder einzeln verfahren zu werden. Auf diese Weise können unterschiedlich große Prüftische mit derselben Wartungseinheit gewartet werden. Über die Säulen sind dann die Seile in den Innenraum des Gestells geführt, wo die Einheit dann aufgehängt ist. Die Einheit ist vorliegend die bereits beschriebene Sensoreinheit, welche auf diese Weise über der Oberfläche aufgehängt ist und gleichsam über der Oberfläche schwebt oder fliegt. Durch dieses Aufhängen von oben hat die Einheit vorteilhaft ein freies Sensorfeld (speziell: Sichtfeld) auf die Oberfläche, welches nicht durch Teile zur Bewegung der Einheit versperrt wird. Analog wird auch die Positionierung der Einheit nicht durch das Gestell eingeschränkt. Ein paralleler Seilroboter hat zudem den Vorteil, dass ein solcher im Vergleich zu anderen Robotern sehr kostengünstig ist.

Alternativ zur Ausgestaltung als paralleler Seilroboter ist eine Ausgestaltung, bei welcher die Wartungseinheit ein Fluggerät ist, insbesondere eine Drohne. Ein Fluggerät ist besonders flexibel, allerdings hinsichtlich Betriebssicherheit und Kosten weniger vorteilhaft als ein paralleler Seilroboter. Vorliegend wird ohne Beschränkung der Allgemeinheit davon ausgegangen, dass die Wartungseinheit ein paralleler Seilroboter ist.

Die Sensoreinheit weist vorzugsweise eine Kamera auf. Eine Kamera ist ein besonders vielseitiger Sensor. Mit der Kamera werden im Rahmen des Verfahrens ein oder mehrere Bilder der Oberfläche oder eines Teils davon aufgenommen und dann von der Wartungseinheit ausgewertet, um einen oder mehrere Schritte des hier beschriebenen Verfahrens zu realisieren. Insbesondere erfolgt dabei eine Bildverarbeitung, d.h. eine Analyse des Bilds, um das Prüfmodul zu erkennen, zu identifizieren, dessen Ist-Zustand festzustellen oder eine Kombination hiervon.

Hierzu ist die Kamera insbesondere derart ausgerichtet, dass diese nach unten und auf die Oberfläche des Prüftisches blickt. Für die Bildverarbeitung wird vorzugsweise eine künstliche Intelligenz verwendet, z.B. um Position, Form oder andere Eigenschaften oder Merkmale des Prüfmoduls zu erkennen.

In einer geeigneten Ausgestaltung wird das Prüfmodul mittels einer Bilderkennung erkannt und identifiziert. Bei der Bilderkennung werden insbesondere ein oder mehrere Bilder ausgewertet, welche mit der bereits beschriebenen Kamera erzeugt wurden. Zur Erkennung des Prüfmoduls enthält die Bilderkennung zweckmäßigerweise einen Algorithmus, welcher die standardmäßige Oberfläche des Prüftisches erkennen und von darauf angeordneten Prüfmodulen unterscheiden kann. Beispielsweise ist die Oberfläche des Prüftisches aus weißen Kacheln zusammengesetzt, welche je nach Bedarf lokal entfernt werden, um dann an der entsprechenden Position stattdessen ein Prüfmodul anzuordnen. Entsprechend kann die Präsenz eines Prüfmoduls durch einen einfachen Farbvergleich und/oder Homogenitätsvergleich erkannt werden. Zur Identifikation wird beispielsweise eine Umrandung, Kontur oder ein oder mehrere Charakteristika des Prüfmoduls bestimmt, hierzu weist die Bilderkennung dann z.B. einen entsprechenden Algorithmus zur Kantenerkennung auf. Alternativ oder zusätzlich werden andere Merkmale zur Identifikation erkannt, z.B. Konturen von Anschlüssen des Prüfmoduls oder bestimmte Farbkombinationen oder dergleichen. Alternativ oder zusätzlich wird das Prüfmodul identifiziert, indem ein oder mehrere Bilder des Prüfmoduls mit Bildern in der Datenbank verglichen werden. Hierzu weist die Bilderkennung einen entsprechenden Abgleichalgorithmus auf, welcher vorzugsweise mittels künstlicher Intelligenz (vorzugsweise trainiert) realisiert ist oder eine solche nutzt. Dies ist besonders vorteilhaft, wenn das Bild des Prüfmoduls verzerrt ist, z.B. weil es nicht aus einem optimalen Winkel aufgenommen wurde. Die Verwendung künstlicher Intelligenz ermöglicht dann dennoch eine zuverlässige Zuordnung zu einem ähnlichen Bild des gleichen Prüfmoduls in der Datenbank und damit die Identifikation des Prüfmoduls als ein solches Prüfmodul, wie in der Datenbank hinterlegt. Allgemein ist der beschriebene Bildvergleich zur Identifikation zweckmäßig bei Prüfmodulen, welche keine ID in Form einer Zeichenfolge oder eines maschinenlesbaren Codes aufweisen oder bei welchen eine solche ID nicht ohne weiteres zugänglich ist. Dann wird einfach ein Bild des Prüfmoduls aufgenommen und die Wartungseinheit ordnet dieses automatisch einem entsprechenden Bild in der Datenbank zu und weiß dann, um welches Prüfmodul es sich handelt.

Alternativ oder zusätzlich zur Identifikation mittels Kantenerkennung ist in einer geeigneten Ausgestaltung die ID an dem Prüfmodul als ein optisch maschinenlesbarer Code angebracht, vorzugsweise als ein QR-Code oder Barcode. Der Code wird insbesondere mit der bereits genannten Kamera einfach eingelesen.

Geeignet ist auch eine Ausgestaltung, bei welcher das Prüfmodul einen Transponder aufweist, vorzugsweise NFC- oder RFID-Transponder, in welchem die ID gespeichert ist. Die Sensoreinheit weist dann ein entsprechendes Lesegerät auf, mit welchem die ID aus dem Prüfmodul ausgelesen wird. Auch in diesem Fall ist die ID maschinenlesbar, jedoch nicht optisch, aber drahtlos. Der Vorteil der Lösung mit Transponder gegenüber dem optisch lesbaren Code ist, dass eine Verschmutzung des Prüfungsmoduls weniger kritisch für die Ermittlung der ID ist.

In einer möglichen Ausgestaltung ist die Oberfläche des Prüftisches größer als ein Blickfeld der Sensoreinheit. Entsprechend wird die Sensoreinheit dann zweckmäßigerweise entlang eines Verfahrwegs über die Oberfläche geführt und sucht dabei den Prüftisch nach Prüfmodulen ab. Dabei steht die Sensoreinheit aber insbesondere nicht in Kontakt mit der Oberfläche, sondern schwebt gleichsam darüber. Der Verfahrweg folgt insbesondere der Form des Prüftisches, sodass dessen gesamte Oberfläche nach und nach von der Sensoreinheit abgefahren wird, vorzugsweise vollständig, um den gesamten Prüftisch zu warten. Sobald beim Absuchen ein Prüfmodul erkannt wird, wird dieses dann auch identifiziert. Die entsprechende Wartungsaktion erfolgt dann entweder noch bevor die Sensoreinheit entlang des Verfahrwegs weitergeführt wird oder es wird zunächst die Oberfläche weiter abgesucht und in einem nachfolgenden, erneuten Durchgang entlang des Verfahrwegs dann die Wartungsaktion durchgeführt.

Der Vergleich von Ist-Zustand und Soll-Zustand wird auch als "Überprüfung" bezeichnet. Die Überprüfung kann auf verschiedenste Weise ausgestaltet sein, nachfolgend werden einige bevorzugte Varianten beschrieben, welche grundsätzlich auch miteinander kombinierbar sind.

In einer ersten Variante überprüft die Wartungseinheit die Anwesenheit (z.B. anwesend oder abwesend, insbesondere an einer bestimmten Stelle in einem vorgegebenen Raster), die Ausrichtung (z.B. verbogen/schräg oder gerade) und/oder die Funktionsfähigkeit (z.B. funktioniert oder defekt) einer Anzahl von Testpins des Prüfmoduls. Der Ist-Zustand gibt dann insbesondere auch an, wie viele Testpins an dem erkannten Prüfmodul tatsächlich festgestellt wurden, z.B. mittels einer Bilderkennung. Der Soll-Zustand gibt an, wie viele Testpins das Prüfmodul aufweisen soll, dies ist z.B. in der Datenbank vorgegeben und wird anhand der ID abgefragt. Stimmt der Ist-Zustand mit dem Soll-Zustand nicht überein, dann ist das Prüfmodul z.B. beschädigt. Als Wartungsaktion wird dann z.B. ein entsprechender Hinweis ausgegeben oder das Prüfmodul automatisch durch ein gleichartiges, aber unbeschädigtes Prüfmodul ausgetauscht. Falls die Funktionsfähigkeit überprüft wird, werden die Testpins mit der Sensoreinheit kontaktiert und dann das Prüfmodul derart angesteuert, dass dieses über die Testpins entsprechende Testsignale aussendet, welche dann von der Sensoreinheit empfangen (Ist-Zustand) werden und mit erwarteten, vorgegebenen Testsignalen (Soll-Zustand) verglichen werden.

In einer zweiten Variante überprüft die Wartungseinheit einen Testdruck des Prüfmoduls, d.h. den Druck, welchen das Prüfmodul an einem entsprechenden hydraulischen Anschluss bereitstellt. Dies erfolgt analog zur Prüfung der Funktionsfähigkeit der Testpins wie oben beschrieben. Der Ist-Zustand gibt dann an, welcher Druck an dem erkannten Prüfmodul tatsächlich bereitgestellt wird. Der Soll-Zustand gibt an, welcher Druck bereitgestellt werden soll, was z.B. in der Datenbank vorgegeben ist und anhand der ID abgefragt wird.

In einer dritten Variante überprüft die Wartungseinheit, ob das Prüfmodul an der korrekten Stelle, d.h. Position auf der Oberfläche, angeordnet ist und/oder korrekt ausgerichtet ist, d.h. eine bestimmte, vorgegebene Orientierung/Ausrichtung/Lage relativ zur Oberfläche aufweist, kurz: ob das Prüfmodul richtig eingebaut ist.

Hierzu wird die Position des Prüfmoduls, z.B. als Wegstrecke entlang des Verfahrwegs, ermittelt (Ist-Zustand) und mit einer vorgegebenen Position (Soll-Zustand) verglichen. Beispielsweise ist in der Datenbank vorgegeben, welche ID an welcher Position der Oberfläche angeordnet sein soll. Die ID und Position des erkannten Prüfmoduls (Ist-Zustand) werden dann entsprechend abgeglichen mit ID und zugeordneter Position in der Datenbank (Soll-Zustand). Auf diese Weise werden insbesondere auch falsch ausgewählte Prüfmodule erkannt, d.h. falls an einer Position ein falsches Prüfmodul angeordnet ist.

Auch für die Wartungsaktion sind verschiedene Ausgestaltungen geeignet. Nachfolgend werden einige bevorzugte Varianten beschrieben, welche grundsätzlich auch miteinander kombinierbar sind

In einer ersten Variante umfasst die Wartungsaktion, dass ein Hinweis ausgegeben wird, z.B. optisch, akustisch, haptisch oder auf andere, insbesondere von einem Techniker wahrnehmbare Weise. Alternativ oder zusätzlich wird der Hinweis einfach automatisch in ein insbesondere elektronisches Wartungsprotokoll eingetragen. Das Wartungsprotokoll ist z.B. Teil der Datenbank. Der Hinweis gibt z.B. einfach an, dass der Ist-Zustand vom Soll-Zustand abweicht.

Auch unabhängig von der konkreten Ausgestaltung der Wartungsaktion ist es vorteilhaft, wenn die Wartungseinheit ein Wartungsergebnis für das Prüfmodul erstellt und automatisch in einem insbesondere elektronischen Wartungsprotokoll für den Prüftisch speichert, z.B. dem bereits zuvor genannten Wartungsprotokoll.

In einer zweiten Variante umfasst die Wartungsaktion, dass das Prüfmodul mit einer Reinigungseinheit, vorzugsweise einem Sauger, gereinigt wird, welche mit der Sensoreinheit mitgeführt wird oder mit der Sensoreinheit verbunden ist (z.B. wird nur ein Saugschlauch der Reinigungseinheit mitgeführt, während die übrige Reinigungseinheit separat z.B. von einem Cobot geführt wird). Die Reinigungseinheit ist somit ein Teil der Wartungseinheit und durch das Mitführen mit der Sensoreinheit auch unmittelbar verfügbar, um etwaige Verschmutzungen zu entfernen.

Die Erkennung von Präsenz und Ist-Zustand des Prüfmoduls, die Ermittlung der ID, das Abrufen des Soll-Zustands, der Vergleich von Ist-Zustand und Soll-Zustand sowie gegebenenfalls die Ausführung einer Wartungsaktion sowie gegebenenfalls die anfängliche Positionierung der Sensoreinheit werden insbesondere wiederholt, bis alles Prüfmodule des Prüftisches entsprechend überprüft wurden und der Prüftisch somit insgesamt gewartet wurde. Typischerweise werden die Prüfmodule nacheinander überprüft, alternativ oder zusätzlich werden mehrere Prüfmodule gleichzeitig überprüft.

Eine erfindungsgemäße Wartungseinheit ist ausgebildet, in einem Verfahren wie vorstehend beschrieben verwendet zu werden, und weist insbesondere eine Steuereinheit auf, um die entsprechenden Verfahrensschritte wie oben beschrieben auszuführen. Vorteilhafte Ausgestaltungen und Varianten ergeben sich analog aus den bisherigen Ausführungen.

Die Aufgabe wird insbesondere auch gelöst durch eine Kombination eines Prüftisches mit einer Wartungseinheit wie oben beschrieben.

Nachfolgend werden Ausführungsbeispiele der Erfindung anhand einer Zeichnung näher erläutert. Darin zeigen jeweils schematisch:
- Fig. 1: ein Verfahren,
- Fig. 2: einen Prüftisch und eine Wartungseinheit,
- Fig. 3: eine Draufsicht auf einen Prüftisch mit mehreren Prüfmodulen,
- Fig. 4: eine Erkennung eines Prüfmoduls und dessen Ist-Zustands,
- Fig. 5: ein Prüfmodul.

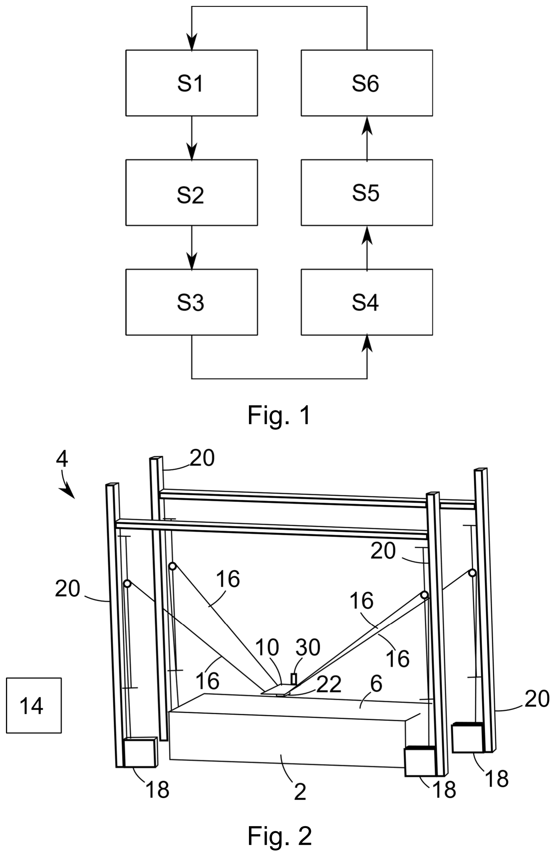

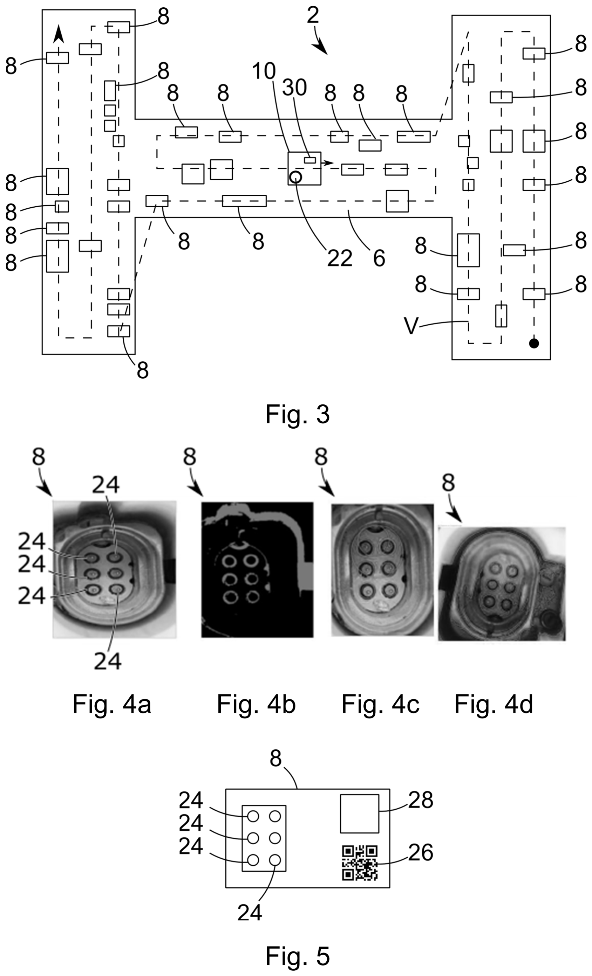

Fig. 1 zeigt ein Ausführungsbeispiel für Verfahren zur Wartung eines Prüftisches 2. In Die Wartung erfolgt mittels einer Wartungseinheit 4, welche separat zu dem Prüftisch 2 ausgebildet ist oder in diesen integriert ist. In Fig. 2 ist ein Ausführungsbeispiel für die Wartungseinheit 4 und den Prüftisch in einer perspektivischen Ansicht gezeigt. Der Prüftisch 2 weist allgemein eine Oberfläche 6 (auch: Oberseite) auf, für welche ein Ausführungsbeispiel in Fig. 3 gezeigt ist. Der Prüftisch 2 weist wenigstens ein Prüfmodul 8, zum Anschließen und Prüfen eines Kabelsatzes (nicht gezeigt). Typischerweise weist der Prüftisch 2 mehrere Prüfmodule 8 auf, wie z.B. in Fig. 3 erkennbar ist. Der Prüftisch 2 ist vorliegend modular, d.h. an verschiedenen Stellen der Oberfläche 6 können verschiedene Prüfmodule 8 je nach konkreter Ausgestaltung des zu prüfenden Kabelsatzes montiert werden.

Das Verfahren ist für verschiedenste Prüftische 2 geeignet, jedoch besonders für sehr große Prüftische 2, und auch für unterschiedliche Formen von Prüftischen 2. In Fig. 3 ist beispielhaft eine H-Form gezeigt, Alternativen sind z.B. U-, I-, und L-Formen.

Die Wartungseinheit 4 weist eine Sensoreinheit 10 auf, welche über der Oberfläche 6 positioniert ist und vorliegend in einem ersten Schritt S1 des Verfahrens über der Oberfläche 6 positioniert wird, nämlich nach und nach an unterschiedlichen Positionen entlang eines Verfahrwegs V. Mit der Sensoreinheit 10 erkennt die Wartungseinheit 4 das Prüfmodul 8 und bestimmt einen Ist-Zustand des Prüfmoduls 8. Mit anderen Worten: in einem zweiten Schritt S2 des Verfahrens erfolgt mit der Sensoreinheit 10 sowohl eine Erkennung der Präsenz des Prüfmoduls 8 sowie eine Erkennung von dessen aktuellen Zustand (Ist-Zustand).

Die Wartungseinheit ermittelt in einem dritten Schritt S3 des Verfahrens eine ID des Prüfmoduls 8, dies erfolgt vorliegend ebenfalls mit der Sensoreinheit 10, welche hierzu entsprechend ausgebildet ist. Durch die Bestimmung der ID wird das Prüfmodul 8 identifiziert, d.h. zusätzlich zur bloßen Erkennung der Präsenz erfolgt auch eine Erkennung, was für ein Prüfmodul 8 konkret vorhanden ist. Die ID beschreibt z.B. einen Typ oder eine Art des Prüfmoduls 8 oder individualisiert dies als ein ganz bestimmtes Prüfmodul 8 aus einer Menge mehrerer Prüfmodule 8. Die ID kann grundsätzlich auf verschiedene Weise von der Wartungseinheit 4 ermittelt werden.

Anhand der ID ruft die Wartungseinheit 4 in einem vierten Schritt S4 aus einer Datenbank 14 einen Soll-Zustand für das Prüfmodul 8 ab. Die ID ist z.B. eine einfache Zeichenfolge im Sinne eines Namens oder einer Seriennummer. Alternativ ist die ID zusammengesetzt aus mehrere Charakteristika des Prüfmoduls 8, z.B. Form, Kontur, Farbe, Anzahl an Testpins usw. Die Datenbank 14 ist entweder separat zur Wartungseinheit 4 ausgebildet oder in diese integriert. Der Soll-Zustand gibt an, welchen Zustand das Prüfmodul 8 aufweisen muss, um für die ordnungsgemäße Prüfung des Kabelsatzes geeignet zu sein. Mit dem "Zustand" (Ist-Zustand oder Soll-Zustand) des Prüfmoduls 8 ist allgemein dessen Art, Typ, Funktion, Konfiguration, Position auf der Oberfläche 6, Funktionsfähigkeit, Betriebsbereitschaft, Verschmutzungsgrad, Beschädigungsgrad oder eine Kombination davon gemeint.

Die Wartungseinheit 4 vergleicht dann in einem fünften Schritt S5 des Verfahrens den Ist-Zustand mit dem Soll-Zustand und führt in einem sechsten Schritt S6 des Verfahrens abhängig davon eine Wartungsaktion für das Prüfmodul 8 automatisch aus. Mit anderen Worten: es erfolgt ein Vergleich von Ist-Zustand und Soll-Zustand, anhand dessen ein möglicher Unterschied zwischen Ist-Zustand und Soll-Zustand festgestellt wird. Anhand des Unterschieds bewertet die Wartungseinheit 4 dann selbsttätig und automatisch, ob eine - und, wenn ja, welche - Wartungsaktion auszuführen ist.

In der Ausgestaltung gemäß Fig. 2 ist die Wartungseinheit 4 ein paralleler Seilroboter, bei welchem die Sensoreinheit 10 an mehreren Seilen 16 über der Oberfläche 6 aufgehängt ist. Der parallele Seilroboter zeichnet sich dadurch aus, dass dieser ein Gestell aufweist, über welches die Seile 16 geführt sind, an welchen die Sensoreinheit 10 dann beweglich gehalten ist. Durch eine geeignete Steuerung von Antrieben 18 (z.B. Motoren) zum Einholen und Ausgeben der Seile 16 wird die Sensoreinheit 10 dann innerhalb des Gestells an verschiedene Positionen bewegt. Das Gestell weist dann mehrere, hier vier vertikale Säulen 20 auf, welche das Innere des Gestells und damit einen Bewegungsraum definieren, welcher für die Sensoreinheit 10 zugänglich ist. Das Gestell kann auch verstellbar sein, z.B. indem die Säulen 20 in horizontaler Richtung und relativ zueinander verfahrbar sind oder indem die Säulen 20 drehbar sind. Über die Säulen 20 sind dann die Seile 16 in den Innenraum des Gestells geführt, wo die Sensoreinheit 10 dann aufgehängt ist und dadurch gleichsam über der Oberfläche 6 schwebt oder fliegt. Alternativ ist auch eine Ausgestaltung der Wartungseinheit 4 als ein Fluggerät, insbesondere eine Drohne, möglich (nicht gezeigt).

Die Sensoreinheit 10 weist vorliegend eine Kamera 22 auf. Mit der Kamera 22 werden im Rahmen des Verfahrens ein oder mehrere Bilder der Oberfläche 6 oder eines Teils davon aufgenommen und dann von der Wartungseinheit 4 ausgewertet, um einen oder mehrere Schritte des hier beschriebenen Verfahrens zu realisieren. Beispielsweise erfolgt dabei eine Bildverarbeitung, d.h. eine Analyse des Bilds, um das Prüfmodul 8 zu erkennen, zu identifizieren, dessen Ist-Zustand festzustellen oder eine Kombination hiervon. Hierzu ist die Kamera 22 derart ausgerichtet, dass diese nach unten und auf die Oberfläche 6 des Prüftisches 2 blickt. In den Fig. 4a bis 4d ist illustriert, wie das Prüfmodul 8 mittels einer Bilderkennung erkannt wird und ein Ist-Zustand des Prüfmoduls 8 ermittelt wird. Optional wird das Prüfmodul 8 auch mit der Bilderkennung identifiziert. Bei der Bilderkennung werden ein oder mehrere Bilder ausgewertet, welche mit der bereits beschriebenen Kamera 22 erzeugt wurden. Zur Erkennung des Prüfmoduls 8 enthält die Bilderkennung einen Algorithmus, welcher die standardmäßige Oberfläche 6 des Prüftisches 2 erkennen und von darauf angeordneten Prüfmodulen 8 unterscheiden kann. Beispielsweise ist die Oberfläche 6 des Prüftisches 2 aus weißen Kacheln zusammengesetzt, welche je nach Bedarf lokal entfernt werden, um dann an der entsprechenden Position stattdessen ein Prüfmodul 8 anzuordnen. Entsprechend kann die Präsenz eines Prüfmoduls 8 durch einen einfachen Farbvergleich und/oder Homogenitätsvergleich erkannt werden. Zur Identifikation wird beispielsweise eine Umrandung oder Kontur des Prüfmoduls 8 bestimmt, hierzu weist die Bilderkennung dann z.B. einen entsprechenden Algorithmus zur Kantenerkennung auf. Alternativ oder zusätzlich werden andere Merkmale zur Identifikation erkannt, z.B. Konturen von Anschlüssen des Prüfmoduls 8 oder bestimmte Farbkombinationen oder dergleichen. In den Fig. 4c und 4d ist eine Kantenerkennung von Testpins 24 des Prüfmoduls 8 gezeigt, hier werden insgesamt sechs Testpins 24 und deren Anordnung erkannt. Jeweils gezeigt ist ein Bild des Prüfmoduls 8, die Fig. 4b, 4c und 4d zeigen dann das verarbeitete Bild, in den Fig. 4c und 4d sind die erkannten Kanten mit grünen Linien markiert. Anhand dessen wird nun zum einen die Präsenz des Prüfmoduls 8 an sich erkannt, optional kann anhand dessen auch das Prüfmodul identifiziert werden, hier als 6-polige, elektrische Anschlussbuchse. Der Übersichtlichkeit halber sind die sechst Testpins 24 in den Fig. 4b, 4c und 4d nicht nochmals mit Bezugszeichen versehen.

Alternativ oder zusätzlich zur Identifikation mittels Kantenerkennung ist die ID an dem Prüfmodul 8 als ein optisch maschinenlesbarer Code 26 angebracht, z.B. als ein QR-Code oder Barcode. Der Code 26 wird z.B. mit der bereits genannten Kamera 22 einfach eingelesen, sodass diese auch zur Ermittlung der ID verwendet wird. Alternativ oder zusätzlich weist das Prüfmodul 8 einen Transponder 28 auf, z.B. einen NFC- oder RFID-Transponder, in welchem die ID gespeichert ist. Die Sensoreinheit 10 weist dann ein entsprechendes Lesegerät auf, mit welchem die ID aus dem Prüfmodul 8 ausgelesen wird. Beide Varianten mit Code 26 und Transponder 28 sind in Fig. 5 illustriert und können unabhängig voneinander oder in Kombination realisiert sein.

Die Oberfläche 6 des Prüftisches 2 ist regelmäßig größer als ein Blickfeld der Sensoreinheit 10. Entsprechend wird die Sensoreinheit 10 dann entlang eines Verfahrwegs V über die Oberfläche 6 geführt und sucht dabei den Prüftisch 2 nach Prüfmodulen 8 ab. Ein beispielhafter Verfahrweg V für einen beispielhaften Prüftisch ist als Strichlinie in Fig. 3 gezeigt. Dabei steht die Sensoreinheit 10 nicht in Kontakt mit der Oberfläche 6, sondern schwebt gleichsam darüber. Der Verfahrweg V folgt der Form des Prüftisches 2, sodass dessen gesamte Oberfläche 6 nach und nach von der Sensoreinheit 10 abgefahren wird, um den gesamten Prüftisch 8 zu warten. Sobald beim Absuchen ein Prüfmodul 8 erkannt wird, wird dieses dann auch identifiziert. In Fig. 3 ist eine Vielzahl an Prüfmodulen 8 in Form von Vierecken gezeigt, welche der Übersichtlichkeit nicht alle mit Bezugszeichen versehen sind. Ebenfalls gezeigt sind die Sensoreinheit 10 und deren Bewegungsrichtung entlang des Verfahrwegs V. Die entsprechende Wartungsaktion erfolgt dann entweder noch bevor die Sensoreinheit 10 entlang des Verfahrwegs V weitergeführt wird (also neu positioniert wird, erster Schritt S1) oder es wird zunächst die Oberfläche 6 weiter abgesucht und in einem nachfolgenden, erneuten Durchgang entlang des Verfahrwegs V dann die Wartungsaktion durchgeführt.

Der Vergleich von Ist-Zustand und Soll-Zustand wird auch als "Überprüfung" bezeichnet. Die Überprüfung kann auf verschiedenste Weise ausgestaltet sein, nachfolgend werden einige Varianten beschrieben, welche grundsätzlich auch miteinander kombinierbar sind.

In einer ersten Variante überprüft die Wartungseinheit 4 die Anwesenheit und/oder die Funktionsfähigkeit einer Anzahl von Testpins 24 des Prüfmoduls 2. Der Ist-Zustand gibt dann an, wie viele Testpins 24 an dem erkannten Prüfmodul 8 tatsächlich festgestellt wurden, z.B. mittels einer Bilderkennung. Der Soll-Zustand gibt an, wie viele Testpins 24 das Prüfmodul 8 aufweisen soll, dies ist z.B. in der Datenbank 14 vorgegeben und wird anhand der ID abgefragt. Stimmt der Ist-Zustand mit dem Soll-Zustand nicht überein, dann ist das Prüfmodul 8 z.B. beschädigt. Als Wartungsaktion wird dann z.B. ein entsprechender Hinweis ausgegeben oder das Prüfmodul 8 automatisch durch ein gleichartiges, aber unbeschädigtes Prüfmodul 8 ausgetauscht. Falls die Funktionsfähigkeit überprüft wird, werden die Testpins 24 mit der Sensoreinheit 10 kontaktiert und dann das Prüfmodul 8 derart angesteuert, dass dieses über die Testpins 24 entsprechende Testsignale aussendet, welche dann von der Sensoreinheit 10 empfangen (Ist-Zustand) werden und mit erwarteten, vorgegebenen Testsignalen (Soll-Zustand) verglichen werden.

In einer zweiten Variante überprüft die Wartungseinheit 4 einen Testdruck des Prüfmoduls 8, d.h. den Druck, welchen das Prüfmodul 9 an einem entsprechenden hydraulischen Anschluss (nicht gezeigt) bereitstellt. Dies erfolgt analog zur Prüfung der Funktionsfähigkeit der Testpins 24 wie oben beschrieben.

In einer dritten Variante überprüft die Wartungseinheit 4, ob das Prüfmodul 8 an der korrekten Stelle, d.h. Position auf der Oberfläche 6, angeordnet ist. Hierzu wird die Position des Prüfmoduls 8, z.B. als Wegstrecke entlang des Verfahrwegs V, ermittelt (Ist-Zustand) und mit einer vorgegebenen Position (Soll-Zustand) verglichen. Beispielsweise ist in der Datenbank 14 vorgegeben, welche ID an welcher Position der Oberfläche 6 angeordnet sein soll. Die ID und Position des erkannten Prüfmoduls 8 (Ist-Zustand) werden dann entsprechend abgeglichen mit ID und zugeordneter Position in der Datenbank 14 (Soll-Zustand).

Auch für die Wartungsaktion sind verschiedene Ausgestaltungen geeignet. Nachfolgend werden einige Varianten beschrieben, welche grundsätzlich auch miteinander kombinierbar sind

In einer ersten Variante umfasst die Wartungsaktion, dass ein Hinweis ausgegeben wird, z.B. optisch, akustisch, haptisch oder auf andere Weise. Alternativ oder zusätzlich wird der Hinweis einfach automatisch in ein elektronisches Wartungsprotokoll eingetragen. Der Hinweis gibt z.B. einfach an, dass der Ist-Zustand vom Soll-Zustand abweicht.

Optional erstellt die Wartungseinheit 4 ein Wartungsergebnis für das Prüfmodul 8 und speichert dieses automatisch in einem Wartungsprotokoll für den Prüftisch 8.

In einer zweiten Variante umfasst die Wartungsaktion, dass das Prüfmodul 8 mit einer Reinigungseinheit 30, hier einem Sauger gereinigt wird, welche mit der Sensoreinheit 10 mitgeführt wird. Die Reinigungseinheit 30 ist somit ein Teil der Wartungseinheit 4 und durch das Mitführen mit der Sensoreinheit 10 auch unmittelbar verfügbar, um etwaige Verschmutzungen zu entfernen.

### Bezugszeichenliste

- 2: Prüftisch
- 4: Wartungseinheit
- 6: Oberfläche
- 8: Prüfmodul
- 10: Sensoreinheit
- 12: ID
- 14: Datenbank
- 16: Seil
- 18: Antrieb
- 20: Säule
- 22: Kamera
- 24: Testpin
- 26: Code
- 28: Transponder
- 30: Reinigungseinheit
- S1: erster Schritt (Positionierung)
- S2: zweiter Schritt (Erkennung von Präsenz und Ist-Zustand)
- S3: dritter Schritt (Identifizierung)
- S4: vierter Schritt (Abrufen des Soll-Zustands)
- S5: fünfter Schritt (Vergleich)
- S6: sechster Schritt (gegebenenfalls Wartungsaktion)
- V: Verfahrweg

## Patentansprüche

1. Verfahren zur Wartung eines Prüftisches (2) mittels einer Wartungseinheit (4),
a. wobei der Prüftisch (2) eine Oberfläche (6) aufweist, mit wenigstens einem Prüfmodul (8) zum Anschließen und Prüfen eines Kabelsatzes,
b. wobei die Wartungseinheit (4) eine Sensoreinheit (10) aufweist, welche über der Oberfläche (6) positioniert ist,
c. wobei die Wartungseinheit (4) mit der Sensoreinheit (10) das Prüfmodul (8) erkennt und einen Ist-Zustand des Prüfmoduls (8) bestimmt,
d. wobei die Wartungseinheit (10) eine ID des Prüfmoduls (8) ermittelt,
e. wobei die Wartungseinheit (4) anhand der ID aus einer Datenbank (14) einen Soll-Zustand für das Prüfmodul (8) abruft,
f. wobei die Wartungseinheit (4) den Ist-Zustand mit dem Soll-Zustand vergleicht und abhängig davon eine Wartungsaktion für das Prüfmodul (8) automatisch ausführt.

2. Verfahren nach Anspruch 1,
wobei die Wartungseinheit (4) ein paralleler Seilroboter ist, bei welchem die Sensoreinheit (10) an mehreren Seilen (16) über der Oberfläche (6) aufgehängt ist,
wobei das Prüfmodul (8) einen Transponder (28) aufweist, vorzugsweise NFC- oder RFID-Transponder, in welchem die ID gespeichert ist.

3. Verfahren nach Anspruch 1,
wobei die Wartungseinheit (4) ein paralleler Seilroboter ist, bei welchem die Sensoreinheit (10) an mehreren Seilen (16) über der Oberfläche (6) aufgehängt ist.

4. Verfahren nach Anspruch 1,
wobei das Prüfmodul (8) einen Transponder (28) aufweist, vorzugsweise NFC- oder RFID-Transponder, in welchem die ID gespeichert ist.

5. Verfahren nach einem der Ansprüche 1 bis 4,
wobei die Sensoreinheit (10) eine Kamera (22) aufweist.

6. Verfahren nach einem der Ansprüche 1 bis 5,
wobei das Prüfmodul (8) mittels einer Bilderkennung erkannt und identifiziert wird.

7. Verfahren nach einem der Ansprüche 1 bis 6,
wobei die ID an dem Prüfmodul (8) als ein optisch maschinenlesbarer Code (26) angebracht ist, vorzugsweise als ein QR-Code oder Barcode.

8. Verfahren nach einem der Ansprüche 1 bis 7,
wobei die Sensoreinheit (10) entlang eines Verfahrwegs (V) über die Oberfläche (6) geführt wird und dabei den Prüftisch (2) nach Prüfmodulen (8) absucht.

9. Verfahren nach einem der Ansprüche 1 bis 8,
wobei die Wartungseinheit (4) die Anwesenheit, die Ausrichtung und/oder die Funktionsfähigkeit einer Anzahl von Testpins (24) des Prüfmoduls (8) überprüft.

10. Verfahren nach einem der Ansprüche 1 bis 9,
wobei die Wartungseinheit (4) einen Testdruck des Prüfmoduls (8) überprüft.

11. Verfahren nach einem der Ansprüche 1 bis 10,
wobei die Wartungseinheit (4) überprüft, ob das Prüfmodul (8) an der korrekten Stelle angeordnet ist und/oder korrekt ausgerichtet ist.

12. Verfahren nach einem der Ansprüche 1 bis 11,
wobei die Wartungsaktion umfasst, dass ein Hinweis ausgegeben wird.

13. Verfahren nach einem der Ansprüche 1 bis 12,
wobei die Wartungsaktion umfasst, dass das Prüfmodul (8) mit einer Reinigungseinheit (30) gereinigt wird, welche mit der Sensoreinheit (10) mitgeführt wird oder mit der Sensoreinheit (10) verbunden ist.

14. Verfahren nach einem der Ansprüche 1 bis 13,
wobei die Wartungseinheit (4) ein Wartungsergebnis für das Prüfmodul (8) erstellt und in einem Wartungsprotokoll für den Prüftisch (2) speichert.

15. Wartungseinheit (4) für ein Verfahren gemäß einem der Ansprüche 1 bis 14.
